# EUROPEAN PATENT APPLICATION

(11) **EP 4 502 994 A1**
(43) Date of publication of application: **05.02.2025**
(21) Application number: 23795135.5
(22) Date of filing: 19.04.2023
(51) Int. Cl.: G09F 9/30

(54) **OPTICAL DISPLAY, SEAT AND VEHICLE**

(30) Priority: 29.04.2022 CN 202210467602
(71) Applicant: Shenzhen Yinwang Intelligent Technologies Co., Ltd., Shenzhen, Guangdong 518129 (CN)
(72) Inventor: LIU, Yuanke, Shenzhen, Guangdong 518129 (CN); LI, Jingke, Shenzhen, Guangdong 518129 (CN); WU, Yu, Shenzhen, Guangdong 518129 (CN)
(74) Representative: Pfenning, Meinig & Partner mbB
(86) International application number: PCT/CN2023/089195
(87) International publication number: WO 2023/207702

(57) **Abstract**

An optical display (303), a seat, and a transport means (1000) are provided. The optical display (303) includes: a display body (32), including a housing (1) and a light source unit (3), where the housing (1) is provided with an inner cavity (101), and the light source unit (3) is accommodated in the inner cavity (101); and an electrical component (37), located outside the housing (1), where the electrical component (37) is electrically connected to the light source unit (3). The electrical component (37) and the light source unit (3) that is located in the inner cavity (101) are not disposed in the same cavity, and the electrical component (37) does not occupy internal space of the housing (1). This helps reduce space occupied by the display body (32). **In** this way, it is convenient to mount the electrical component (37) and the display body (32) in different space based on a requirement, and mounting flexibility of the optical display is improved.

## Description

This application claims priority to Chinese Patent Application No. 202210467602.2, filed with the China National Intellectual Property Administration on April 29, 2022 and entitled "OPTICAL DISPLAY, SEAT, AND TRANSPORT MEANS", which is incorporated herein by reference in its entirety.

### TECHNICAL FIELD

This application relates to the field of display body technologies, and in particular, to an optical display, a seat, and a transport means.

### BACKGROUND

An optical display is a device using an optical imaging principle to obtain large-screen visual experience in small space, and may be widely used in a projector, a head-up display (head-up display, HUD), a vehicle-mounted display, a vehicle light, and the like.

The optical display usually includes an optical component and an electrical component that are disposed in a same cavity. The optical component includes a light source for emitting imaging light and another optical element. The electrical component may be electrically connected to the light source to supply power, and the like. For imaging requirements, a cavity of the optical component needs to occupy a large volume. However, if the optical component and the electrical component are disposed in the same cavity, the cavity of the optical display may be larger. This is not conducive to application of the optical display in narrow mounting space.

### SUMMARY

Implementations of this application provide an optical display whose space occupied in a thickness direction is reduced, a seat, and a transport means.

According to a first aspect, this application provides an optical display. The optical display includes:
a display body, including a housing and a light source unit, where the housing is provided with an inner cavity, and the light source unit is accommodated in the inner cavity; and
an electrical component, located outside the housing, where the electrical component is electrically connected to the light source unit.

In this application, the electrical component is disposed outside the housing. In other words, the electrical component and the light source unit that is located in the inner cavity are not disposed in the same cavity, and the electrical component does not occupy internal space of the housing. This helps reduce space occupied by the display body. In this way, it is convenient to mount the electrical component and the display body in different space based on a requirement, and mounting flexibility of the optical display is improved. For example, when the optical display is mounted to a seat, the display body may be mounted to a head pillow part, and the electrical component may be mounted below a head pillow.

In addition, the electrical component is disposed outside the housing, and a heat dissipation structure for heat dissipation of the electrical component does not need to be disposed on the housing. This reduces a quantity of times of reflection of veiling glare in an optical path inside the housing, and helps improve output quality of imaging light that is output by the display body, and improve display quality of the optical display.

In addition, in a conventional optical display, to ensure a display effect, because an optical component and an electrical component are disposed in a same cavity, and design requirements (for example, sealing levels) of the optical component and the electrical component for a structure are different, a structure of the optical display may be complex. However, in this application, the electrical component is disposed outside the housing, so that the electrical component and an optical element in the inner cavity are independent of each other in terms of structure. This helps simplify a structure of the optical display.

According to the first aspect, in a possible implementation of this application, the electrical component includes a main controller and a first cable, and the first cable is electrically connected between the light source unit and the main controller.

The first cable is configured to transmit, to the light source unit, an image signal (for example, a video) output by the main controller, and supply power to the light source unit, to ensure stable output of the light source unit.

According to the first aspect, in a possible implementation of this application, the electrical component further includes a pitch mechanism communicatively connected to the main controller, the pitch mechanism is connected to the housing and is located outside the housing, and the pitch mechanism is configured to drive the display body to rotate.

The pitch mechanism may adjust an angle of the display body, to adapt to watching requirements of users who have different heights, have different sitting postures, and even stand, so as to improve use convenience of the optical display.

According to the first aspect, in a possible implementation of this application, the electrical component further includes a control panel, the control panel is communicatively connected to the pitch mechanism, and the control panel is communicatively connected to the main controller.

A user may control movement of the pitch mechanism through the control panel, to control a rotation angle of the display body. This improves use convenience of the optical display. The control panel may be further configured to control brightness of the display body, and the like.

According to the first aspect, in a possible implementation of this application, the pitch mechanism includes a transmission assembly and a driving piece, the transmission assembly is connected between the housing and the driving piece, and the driving piece is communicatively connected to the control panel.

A driving force of the driving piece is transferred to the display body through the transmission assembly, to drive the display body to rotate. This facilitates a device layout and power transfer of the pitch mechanism.

According to the first aspect, in a possible implementation of this application, the electrical component further includes a third cable. The third cable is electrically connected between the main controller and the driving piece, and is configured to transmit, to the driving piece, a driving signal output by a main control board, so that the main controller controls the driving piece.

According to the first aspect, in a possible implementation of this application, the electrical component further includes a fourth cable. The fourth cable is electrically connected between the main controller and the control panel, so that the user controls the display body through the control panel.

According to the first aspect, in a possible implementation of this application, the transmission assembly includes a first transmission structure and a second transmission structure that are disposed in a connected manner, the first transmission structure is connected to the driving piece, and the second transmission structure is fixedly connected to the housing.

According to the first aspect, in a possible implementation of this application, the first transmission structure includes a worm, the worm is fixedly connected to the driving piece, the second transmission structure includes a worm gear, the worm gear is fastened to the housing, and the worm is engaged with the worm gear.

The worm has a self-locking function, so that the display body can be hovered at any angle within a pitch rotation range. This improves position stability of the display body. Even if the display body is constantly vibrated (for example, the display body is mounted in a vehicle, and the vehicle is in a bumpy road condition), a position of the display body can still be kept stable, and no abnormal sound is generated due to shaking.

According to the first aspect, in a possible implementation, the worm includes a worm head and a rod body that are fixedly connected, the worm head is engaged with the second transmission structure, and one end that is of the rod body and that is away from the worm head is connected to the driving piece.

The driving piece is connected to the rod body to drive the worm head to rotate. For example, when the optical display is mounted in the seat, an area in which a light outlet side of the optical display is located is usually an area in which the head pillow of the seat is located. However, running of the driving piece usually generates vibration. If the driving piece is disposed close to the display body, it is likely that experience of a user taking the seat is poor. The rod body is disposed, so that the driving piece is spaced at a distance from a head pillow area. This helps reduce impact of the driving piece on the user taking the seat.

According to the first aspect, in a possible implementation of this application, the optical display further includes a package housing, and the pitch mechanism is at least partially accommodated in the package housing.

The pitch mechanism is accommodated in the package housing, and the package housing may have effects such as dust prevention, noise reduction, vibration resistance, and impact resistance.

According to the first aspect, in a possible implementation of this application, the main controller includes a main control chip and a protective housing. The main control chip is fixedly accommodated in the protective housing. A heat dissipation structure is disposed on the protective housing, and the heat dissipation structure is configured to dissipate heat generated by the main control chip.

According to the first aspect, in a possible implementation of this application, the display body further includes a curved mirror, the curved mirror is fastened to the housing, and the curved mirror is configured to project, to the outside of the housing, imaging light that is output by the light source unit.

According to the first aspect, in a possible implementation of this application, the display body further includes a transflective optical element, the imaging light emitted by the light source unit is incident to the transflective optical element, the transflective optical element reflects imaging light to the curved mirror, and the curved mirror transmits the imaging light to the outside of the housing through the transflective optical element.

According to a second aspect, a seat is provided. The seat includes a seat body and the foregoing optical display. The seat body is provided with an accommodating cavity, and a display body and an electrical component are at least partially accommodated in the accommodating cavity.

Because the electrical component and an optical component are separately disposed, when the optical display is mounted to the seat, the electrical component and the optical component may be separately disposed on different parts of the seat.

According to the second aspect, in a possible implementation of this application, the seat body further includes a head pillow area and a leaning area that are disposed in a connected manner, and the display body is located in the head pillow area. The display body may be mounted to a corresponding part of a head pillow of the seat, and an electrical part may be extended to the leaning area. In this way, space utilization of the accommodating cavity of the seat is improved.

According to the second aspect, in a possible implementation of this application, the seat body further includes a framework accommodated in the accommodating cavity, the electrical component includes a main controller and a first cable, the first cable is electrically connected between a light source unit and the main controller, the main controller is fastened to the framework and is accommodated in the accommodating cavity, and the main controller is located in the leaning area.

Because the main controller is located in the leaning area and does not occupy space of the head pillow area, mounting flexibility of the optical display and space utilization of the accommodating cavity are improved.

According to the second aspect, in a possible implementation of this application, the electrical component further includes a pitch mechanism and a control panel that are communicatively connected, the pitch mechanism is connected to a housing, and the pitch mechanism is communicatively connected to the main controller. The control panel may be fastened to the framework.

Because the control panel is located in the leaning area and does not occupy space of the head pillow area, mounting flexibility of the optical display and space utilization of the accommodating cavity are improved.

According to the second aspect, in a possible implementation of this application, the pitch mechanism has a driving piece, the electrical component further includes a third cable and a fourth cable, the third cable is electrically connected between the main controller and the driving piece, the fourth cable is electrically connected between the control panel and the main controller, and the driving piece is fastened to the framework.

When the driving piece drives the display body to rotate, a position of the display body relative to each component of the electrical component needs to be continuously changed to adapt to a viewer, that is, the display body and the electrical component move relative to each other, and cables between the display body and the electrical component need to be redundant to reduce cable movement as much as possible. Because the driving piece, the control panel, and the main controller are all fastened to the framework, when the display body rotates, only the light source unit rotates with the display body, and the driving piece, the control panel, and the main controller are static relative to each other. Therefore, the first cable between the light source unit and the main controller needs to be redundant, to reduce a redundancy of the third cable between the main controller and the driving piece, and reduce a redundancy of the fourth cable between the control panel and the main controller.

According to a third aspect, this application provides a transport means, including the foregoing optical display. A housing is mounted on the transport means.

According to the third aspect, in a possible implementation of this application, the optical display is located in a front passenger position of the transport means.

According to the third aspect, in a possible implementation of this application, the transport means includes a vehicle door, and a control panel is mounted on the vehicle door, to facilitate a user to operate the control panel.

### BRIEF DESCRIPTION OF DRAWINGS

FIG. 1 is a diagram of an application scenario of a transport means according to an implementation of this application;
FIG. 2 is a diagram of an application scenario of a first seat according to an implementation of this application;
FIG. 3 is a three-dimensional sectional view of a first seat according to a first implementation of this application;
FIG. 4 is a three-dimensional exploded diagram of an optical display according to a first implementation of this application;
FIG. 5 is a three-dimensional sectional view of a part of a structure of an optical display according to a first implementation of this application;
FIG. 6 is a diagram of an optical path of an optical display according to a first implementation of this application;
FIG. 7 is a three-dimensional diagram of a housing according to a first implementation of this application;
FIG. 8 is a diagram of an application scenario of an optical display according to a first implementation of this application;
FIG. 9 is a three-dimensional sectional view of a first seat according to a first implementation of this application;
FIG. 10 is a diagram of three-dimensional assembly of a control panel and a framework according to a first implementation of this application;
FIG. 11a is a three-dimensional diagram of a main controller according to a first implementation of this application;
FIG. 11b is a three-dimensional diagram of a main controller from another perspective according to a first implementation of this application;
FIG. 12 is a diagram of a scenario in which a control panel is mounted on a vehicle door according to an implementation of this application;
FIG. 13a is a three-dimensional diagram of a first seat according to a second implementation of this application;
FIG. 13b is a diagram of three-dimensional assembly of an optical display and a framework shown in FIG. 13a;
FIG. 13c is a three-dimensional exploded diagram of a part of a structure of the optical display and the framework shown in FIG. 13b;
FIG. 13d is a three-dimensional exploded diagram of the optical display and the framework shown in FIG. 13b;
FIG. 13e is a exploded diagram of a part of a structure of a pitch mechanism of the optical display shown in FIG. 13d;
FIG. 14 is a three-dimensional diagram of an optical display including a multi-head worm according to an implementation of this application;
FIG. 15a is a three-dimensional diagram of a first seat according to a possible implementation of this application;
FIG. 15b is a three-dimensional diagram of a first seat according to a possible implementation of this application;
FIG. 15c is a three-dimensional diagram of a first seat according to a possible implementation of this application;
FIG. 16a is a three-dimensional diagram of a first seat according to a possible implementation of this application;
FIG. 16b is a rear view of the first seat shown in FIG. 16a;
FIG. 16c is a sectional view of the first seat shown in FIG. 16b along a line B-B;
FIG. 17a is a three-dimensional diagram of a first seat according to a third implementation of this application;
FIG. 17b is a three-dimensional exploded diagram of an optical display of the first seat shown in FIG. 17a;
FIG. 18a is a three-dimensional diagram of a first seat according to a fourth implementation of this application;
FIG. 18b is a three-dimensional exploded diagram of an optical display of the first seat shown in FIG. 19a;
FIG. 19a is a three-dimensional diagram of a first seat according to a fifth implementation of this application;
FIG. 19b is a three-dimensional exploded diagram of an optical display of the first seat shown in FIG. 19a;
FIG. 20a is a three-dimensional diagram of a first seat according to a sixth implementation of this application;
FIG. 20b is a three-dimensional diagram of a part of a structure of an optical display of the first seat shown in FIG. 20a;
FIG. 20c is a enlarged diagram of a part of an area in FIG. 20b;
FIG. 21a is a three-dimensional diagram of a first seat according to a seventh implementation of this application;
FIG. 21b is a three-dimensional diagram of a part of a structure of an optical display of the first seat shown in FIG. 21a;
FIG. 22a is a three-dimensional diagram of a first seat according to an eighth implementation of this application;
FIG. 22b is a three-dimensional diagram of a part of a structure of an optical display of the first seat shown in FIG. 22a;
FIG. 23a is a three-dimensional diagram of a first seat according to a ninth implementation of this application;
FIG. 23b is a three-dimensional diagram of a part of a structure of an optical display of the first seat shown in FIG. 23a;
FIG. 23c is a enlarged diagram of a part of an area of the optical display shown in FIG. 23b;
FIG. 24a is a three-dimensional diagram of a first seat according to a tenth implementation of this application;
FIG. 24b is a three-dimensional diagram of a part of a structure of an optical display of the first seat shown in FIG. 24a;
FIG. 25a is a three-dimensional diagram of a first seat according to an eleventh implementation of this application;
FIG. 25b is a three-dimensional diagram of a part of a structure of an optical display of the first seat shown in FIG. 25a;
FIG. 26 is a three-dimensional exploded diagram of a first seat according to a twelfth implementation of this application;
FIG. 27 is a functional block diagram of a transport means according to an implementation of this application;
FIG. 28 is a diagram of integrating an optical display into a near-eye device according to this application; and
FIG. 29 is a diagram of integrating an optical display into a projector according to this application.

### DESCRIPTION OF EMBODIMENTS

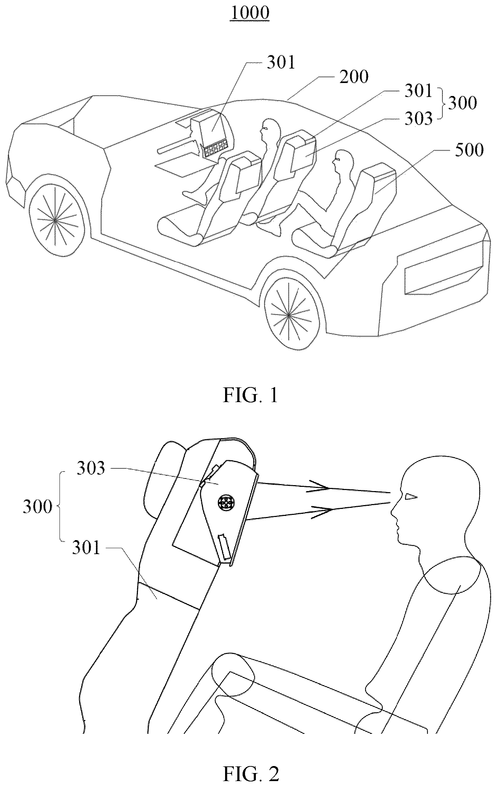

Refer to FIG. 1. An implementation of this application provides a transport means 1000. The transport means 1000 in the implementation of this application may be a known transport means, for example, a vehicle, an airplane, a ship, or a rocket, or may be a future transport means. The vehicle may be an electric vehicle, a fuel vehicle, or a hybrid power vehicle, for example, a pure electric vehicle, an extended-range electric vehicle, a hybrid electric vehicle, a fuel cell vehicle, or a new energy vehicle. This is not specifically limited in this application.

The transport means 1000 includes a tool body 200 and a seat mounted on the tool body 200. The seat includes a first seat 300 and a second seat 500 for passenger seating. In this implementation, the first seat 300 is a front-row seat disposed in the tool body 200, and the second seat 500 is a rear-row seat arranged behind the first seat 300 for passenger seating. In another implementation of this application, the first seat 300 may not be a front-row seat.

Refer to FIG. 2. The first seat 300 includes a seat body 301 and an optical display 303 mounted on the seat body 301. In this application, a passenger who takes the second seat 500 and watches the optical display 303 is referred to as a viewer. It may be understood that the optical display 303 may alternatively be mounted at a front passenger position (as shown in FIG. 1) of the transport means 1000, that is, mounted on an instrument panel (Instrument Panel, IP) of the transport means.

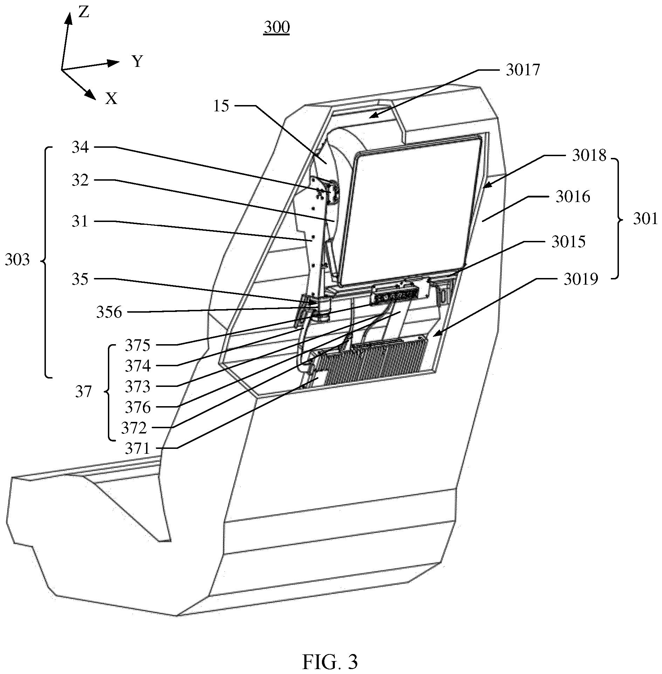

Refer to FIG. 3. The seat body 301 further includes a framework 3015 and a cover 3016. The framework 3015 is configured to shape the first seat 300 and is used for load bearing. The cover 3016 wraps the framework 3015, so that the first seat 300 includes an accommodating cavity 3017. The cover 3016 usually includes a flexible filler, to improve comfort of a user taking the first seat 300. The accommodating cavity 3017 is configured to accommodate the optical display 303.

The seat body 301 further includes a head pillow area 3018 and a leaning area 3019. The head pillow area 3018 corresponds to a head area that is of the seat body 301 and that supports the passenger. The leaning area 3019 corresponds to another area of the seat body 301. The optical display 303 is located in the head pillow area 3018 of the first seat 300, so that the viewer on the second seat 500 can keep a horizontal view of the optical display 303, so as to improve viewing comfort of the viewer.

The optical display 303 is at least partially accommodated in the accommodating cavity 3017, and the optical display 303 can be exposed from the cover 3016, to output imaging light that carries image information to the outside of the seat body 301. The optical display 303 includes a support 31, a display body 32, a package housing 34, a pitch mechanism 35, and an electrical component 37.

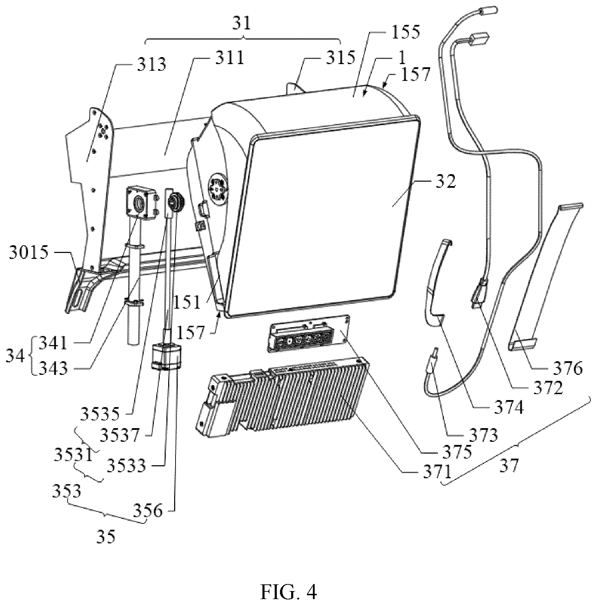

The support 31 is fastened to the framework 3015 of the first seat 300, is accommodated in the accommodating cavity 3017, and is configured to support the display body 32. The display body 32 is accommodated in the accommodating cavity 3017 and is located in the head pillow area 3018. Refer to FIG. 3 and FIG. 4. The display body 32 is rotatively connected to the support 31, and is configured to output the imaging light that carries the image information. The package housing 34 is fastened to the support 31, and is configured to accommodate and protect the pitch mechanism 35, so as to perform functions such as dust prevention, noise reduction, vibration resistance, and impact resistance. The pitch mechanism 35 is accommodated in the package housing 34. The pitch mechanism 35 is connected between the support 31 and the display body 32. The pitch mechanism 35 is configured to drive the display body 32 to rotate relative to the support 31, to adapt to watching requirements of people who have different heights, have different sitting postures, and even stand, so as to improve use convenience of the user. The electrical component 37 is disposed on the first seat 300, is located outside the display body 32, and is configured to provide electric energy, input an image signal, and the like for the display body 32.

When the optical display 303 is mounted in the first seat 300, because a framework structure of the vehicle-mounted seat is complex, space that can be reserved in the first seat 300 for the optical display is limited and dispersed. In a thickness direction of the first seat 300 (an arrangement direction of the first seat 300 and the second seat 500), mounting space reserved for the optical display 303 is very limited. However, due to a requirement of optical imaging, the optical display 303 needs a large optical cavity.

In the optical display of this application compared with a conventional optical display in which an electrical component and an optical component are disposed in a same cavity, the electrical component 37 is disposed outside the display body 32, and does not occupy internal space of the display body 32, that is, the electrical component 37 and an internal optical element of the display body 32 are disposed in different cavities. This helps reduce space occupied by the optical cavity of the display body 32 and helps miniaturize the display body 32. Components such as the display body 32 and the electrical component 37 may be mounted and arranged based on internal space of the accommodating cavity 3017, so that mounting flexibility of the optical display 303 is improved, and space utilization of the accommodating cavity 3017 in the first seat 300 is also improved.

In addition, the electrical component 37 generates heat when working. Because the electrical component 37 is disposed outside the display body 32, a heat dissipation structure for heat dissipation of the electrical component 37 does not need to be disposed on the display body 32. Because no heat dissipation structure is disposed on the display body 32, a quantity of times of reflection of veiling glare in an optical path inside the display body 32 is reduced. This helps improve output quality of the imaging light that is output by the display body 32, and improve display quality of the optical display 303.

The support 31 includes a support part 311, a first support arm 313, and a second support arm 315. The support part 311 is connected between the first support arm 313 and the second support arm 315. The package housing 34 is fastened to the first support arm 313. The package housing 34 is located between the first support arm 313 and the display body 32. The pitch mechanism 35 is connected between the first support arm 313 and the display body 32. The first support arm 313 and the second support arm 315 may be fastened to the framework 3015 through welding, fastener connection, or the like. A manner of fastening the support 31 and the framework 3015 is not limited in this application. In another implementation of this application, the support 31 may be omitted, and the display body 32 is directly rotatively connected to a structure like the framework 3015.

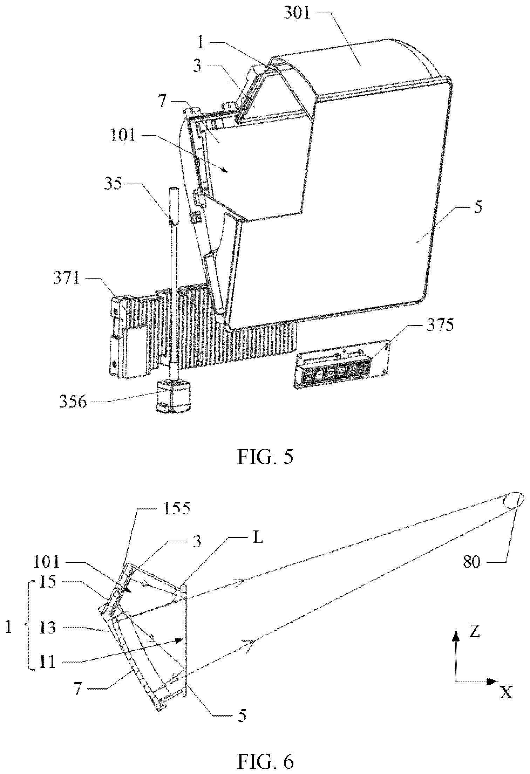

Refer to FIG. 5. The display body 32 includes a housing 1, a light source unit 3, a transflective optical element 5, and a curved mirror 7. The housing 1 is provided with an inner cavity 101. The light source unit 3 is fastened to the housing 1, is accommodated in the inner cavity 101, and is configured to emit imaging light. The transflective optical element 5 is fastened to the housing 1, and is configured to transmit and reflect the imaging light. The transflective optical element 5 is exposed out of the seat body 301, to enable the viewer to look at the transflective optical element 5 horizontally. The transflective optical element 5 is a light outlet surface of the display body 32. The curved mirror 7 is fastened to the housing 1 and is configured to reflect the imaging light. The electrical component 37, the package housing 34, and the pitch mechanism 35 are located outside the inner cavity 101. The housing 1, the light source unit 3, the transflective optical element 5, and the curved mirror 7 jointly form an optical path cavity (optical cavity for short) of the optical display 303, to form an optical path of the imaging light inside the display body 32. It may be understood that a structure of the display body 32 is not limited in this application, and the display body 32 may include another optical element, for example, a reflector.

As shown in FIG. 6, the imaging light emitted by the light source unit 3 is reflected to the curved mirror 7 through the transflective optical element 5, and imaging light reflected by the curved mirror 7 is transmitted to the outside of the housing 1 through the transflective optical element 5. The light source unit 3 may be referred to as an image source. The transflective optical element 5 may reflect the imaging light emitted by the light source unit 3 to the curved mirror 7. The imaging light reflected by the curved mirror 7 is transmitted to the outside of the housing 1 through the transflective optical element 5, and then enters an eye 80. The eye 80 sees an enlarged virtual image. The virtual image may be viewed by the eye 80 without being received by a light screen. As shown in FIG. 6, the light source unit 3 emits imaging light L with a specific divergence angle, and after being reflected by the transflective optical element 5 and the curved mirror 7, the imaging light L enters the eye 80. The brain traces the light reversely based on experience of "light travels in a straight line", and considers an intersection point of reverse extension lines of the imaging light L as an object point, namely, a virtual image point.

In this application, because the light source unit 3, the transflective optical element 5, and the curved mirror 7 are all directly fastened to the same housing 1 without using another adapter (for example, respective fastening frame bodies), a quantity of elements of the optical display 303 is reduced, assembly difficulty of the optical display 303 is reduced, assembly precision of the optical display 303 is improved, and a structure of the optical display 303 is simplified, so as to help improve precision of an optical path system of the optical display 303 and improve output quality of the imaging light of the optical display 303.

In addition, relative positions of the light source unit 3, the transflective optical element 5, and the curved mirror 7 are determined according to an optical principle. This helps improve a display effect of the optical display 303. Constituent parts (the light source unit 3, the transflective optical element 5, and the curved mirror 7) of the optical component are integrated in the housing 1, and the electrical component 37 is located outside the housing 1. This helps perform a sealing design (including a dustproof and waterproof structure) based on protection levels required by the optical component and the electrical component 37, to effectively prevent a large-granularity substance from entering the inner cavity 101 of the housing 1, so as to ensure a display effect of the optical display 303.

In some implementations of this application, the housing 1 includes a light outlet part 11, a back part 13, and a connecting side part 15. The light outlet part 11, the back part 13, and the connecting side part 15 jointly form the inner cavity 101. The light outlet part 11 and the back part 13 are disposed opposite to each other in a first direction (an X direction shown in FIG. 3 and FIG. 6) of the display body 32. In this implementation, the light outlet part 11 includes a transparent area in communication with the inner cavity 101. A normal direction of the light outlet part 11 is in the first direction. The curved mirror 7 and the light source unit 3 are located in the inner cavity 101. The transflective optical element 5 fixedly covers the light outlet part 11. In the first direction of the display body 32, the curved mirror 7 is located between the back part 13 and the transflective optical element 5. The connecting side part 15 is connected between the light outlet part 11 and the back part 13. The pitch mechanism 35 is connected to the connecting side part 15 (as shown in FIG. 3), and is configured to drive the display body 32 to rotate relative to the support 31 around a first rotation axis disposed in a second direction (a Y direction shown in FIG. 3) of the display body 32. The curved mirror 7 is fastened to the connecting side part 15 or the back part 13, and is configured to reflect, to the outside of the housing 1 through the light outlet part 11, the imaging light reflected by the transflective optical element 5, for the user to view.

Because the pitch mechanism 35 is connected to the connecting side part 15, the pitch mechanism 35 is disposed away from the back part 13, so that space that is occupied by the pitch mechanism 35 and that is of the display body 32 in the first direction (the thickness direction) is reduced or the pitch mechanism 35 does not occupy space of the display body 32 in the first direction (the thickness direction), and space occupied by the optical display 303 in the first direction is reduced. This facilitates mounting of the optical display 303 in the narrow accommodating cavity 3017.

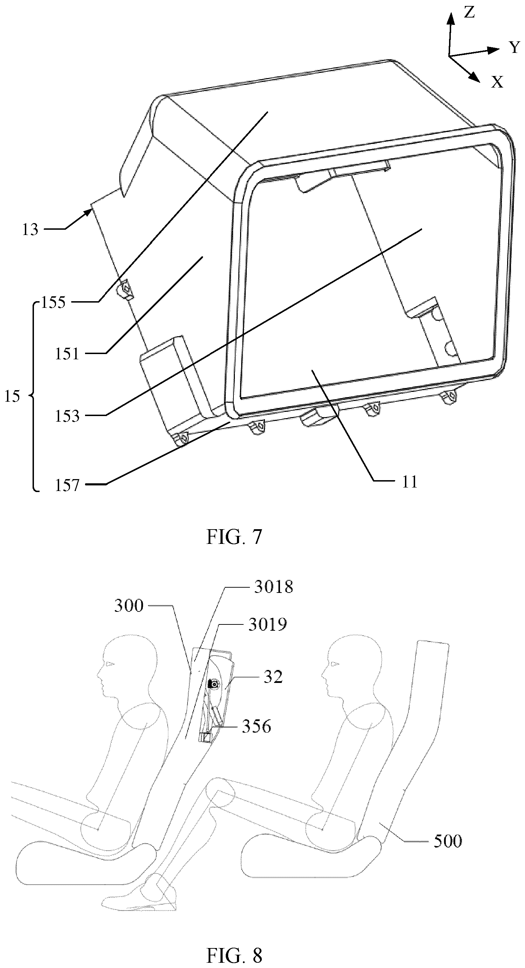

Refer to FIG. 6 and FIG. 7. The connecting side part 15 includes a first side part 151, a second side part 153, a third side part 155, and a fourth side part 157. The first side part 151 and the second side part 153 are disposed opposite to each other in the second direction (a Y direction shown in FIG. 7), and the third side part 155 and the fourth side part 157 are disposed opposite to each other in a third direction (a Z direction shown in FIG. 7). The third side part 155 may be considered as a top of the display body 32, and the fourth side part 157 may be considered as a bottom of the display body 32. The light source unit 3 is fastened to the third side part 155 (as shown in FIG. 6). It may be understood that structures of the housing 1 and the display body 32 are not limited in this application, provided that the housing 1 carries optical elements such as the light source unit 3, and the display body 32 includes the light outlet part 11, the back part 13, and the connecting side part 15.

In the third direction of the display body 32, in a direction from the third side part 155 to the fourth side part 157, a position of the light source unit 3 is higher than those of the curved mirror 7 and the transflective optical element 5. Therefore, when the user views the optical display 303, it is difficult to see, through the transflective optical element 5, the light source unit 3 located on the third side part 155. This is equivalent to that the light source unit 3 is hidden in the third side part 155, and veiling glare of the light source unit 3 is not directly transmitted to human eyes through the transflective optical element 5. This helps improve use experience of the user and also improve imaging quality of the optical display 303.

In some implementations of this application, the light source unit 3 uses a liquid crystal display (liquid crystal display, LCD) imaging technology. LCD imaging uses a photoelectric effect principle of liquid crystals. An arrangement state of liquid crystal molecules changes due to impact of an external electric field. Liquid crystal molecules in different arrangement states can control a light transmittance. For example, there are liquid crystal molecules in the middle of two polarizers whose polarization directions are perpendicular to each other. When no electric field is applied, the liquid crystal molecules can rotate a polarization direction of linearly polarized light passing through the first polarizer by 90°. In this case, the light passes through the second polarizer at a maximum transmittance. When an electric field is applied, an arrangement state of the liquid crystal molecules changes, a rotation angle of polarized light also changes, and intensity of the light passing through the second polarizer accordingly decreases. Each pixel of an LCD display includes three primary colors. A color picture is displayed by controlling intensity of the three primary colors. A type of a light source of the light source unit 3 is not limited in this application. For example, the light source unit 3 may alternatively use a digital light processing (digital light processing, DLP) technology, laser scanning projection, or the like.

The transflective optical element 5 is an optical element that can transmit a part of incident light incident to the transflective optical element 5 and reflect a part of incident light. For example, the transflective optical element may transmit 50% incident light, and the transflective optical element may reflect 50% incident light; or the transflective optical element may transmit 30% incident light, and the transflective optical element may reflect 70% incident light. A percentage of incident light transmitted by the transflective optical element 5 to the overall incident light may be selected based on a requirement. A material of the transflective optical element 5 may be glass or the like.

In this implementation, the curved mirror 7 is a reflector, having a free-form surface, that matches an optical imaging requirement.

A surface of an optical element used in a conventional optical design is a standard spherical surface. Usually, a plurality of spherical mirrors need to cooperate to correct an aberration. Consequently, an optical structure of the optical element is complex, and large space is occupied.

As the optical industry develops, design and manufacturing technologies of complex aspheric surfaces are greatly improved. Aspheric surfaces are usually quadratic surfaces such as a parabolic surface, an ellipsoidal surface, an involute surface, and a hyperbolic surface with an axis of rotation, high-order surfaces, and non-rotational aspheric surfaces such as an off-axis aspheric surface. In different use scenarios, one aspheric surface may usually replace two or more spherical surfaces to correct an aberration, to simplify the optical structure and implement miniaturization and lightweight of an optical path.

Compared with the aspheric surface, a free-form surface is a more complex optical structure. A curvature radius of each point on the surface is different, and a degree of freedom of the surface is very high. The free-form surface can not only replace a plurality of aspheric surfaces to correct an aberration, but also maximally improve optical quality and simplify the optical structure. An optical free-form surface has a complex structure, a high degree of freedom, and no clear expression definitions. Generally, an optical surface that does not have global rotational symmetry, does not have a unified optical axis, and has a plurality of curvature radii on the entire surface is considered as an optical free-form surface.

In another implementation of this application, the curved mirror 7 may alternatively be a spherical reflector or an aspheric reflector. This is not limited in this application.

Refer to FIG. 3 and FIG. 4 again. In some implementations of this application, the package housing 34 includes a first packaging part 341 and a second packaging part 343 that are disposed in a connected manner. The pitch mechanism 35 includes a transmission assembly 353 and a driving piece 356. The transmission assembly 353 is connected between the display body 32 and the first support arm 313.

The transmission assembly 353 includes a first transmission structure and a second transmission structure. The first transmission structure is located on a side on which the first side part 151 of the display body 32 is located. The first transmission structure can rotate around a second rotation axis. The second transmission structure is connected to the display body 32. A rotational movement of the first transmission structure around the second rotation axis is converted into a rotational movement of the second transmission structure and the display body 32 around the first rotation axis, to reduce space occupied by the pitch mechanism 35.

In this implementation, the first transmission structure includes a worm 3531, and the second transmission structure includes a worm gear 3533. The worm 3531 includes a worm head 3535 and a rod body 3537 that are fixedly connected. Both the worm head 3535 and the worm gear 3533 are accommodated in the first packaging part 341. The rod body 3537 is accommodated in the second packaging part 343. The worm head 3535 is engaged with the worm gear 3533. One end of the rod body 3537 is fixedly connected to the worm head 3535. The worm gear 3533 is sleeved outside the rotating shaft 3515 in a manner of stopping rotating. In this implementation, the worm 3531 is a single-head worm, and the single-head worm has a strong self-locking function. Generally, a position of the optical display body 32 is not easily changed by an external force.

Cooperation between the worm gear 3533 and the worm 3531 has a self-locking function, so that the display body 32 can be hovered at any angle within a pitch rotation range, to improve position stability of the display body 32. Even if the display body 32 is constantly vibrated (for example, the transport means 1000 travels in a bumpy road condition), the display body 32 can still be kept stable in position relative to the support 31, and does not shake to generate abnormal noise, so as to improve use reliability of the optical display 303.

The driving piece 356 is connected to an end that is of the rod body 3537 and that is away from the worm head 3535, is located outside the package housing 34, and is configured to provide a driving force for the display body 32. The driving piece 356 drives, through the worm 3531, the worm gear 3533 to rotate, so as to drive the display body 32 to rotate relative to the support 31. It may be understood that, in another implementation, the driving piece 356 may also be accommodated in the package housing 34, to be protected by the package housing 34.

In this implementation, the rod body 3537 movably penetrates the framework 3015, and the driving piece 356 is fastened to the framework 3015 and is located in the leaning area 3019. Refer to FIG. 8. The driving piece 356 is disposed in the leaning area 3019, so that the driving piece 356 is away from the head pillow area 3018 and away from an ear of the passenger taking the first seat 300. In addition, the driving piece 356 is accommodated in the accommodating cavity 3017, and the cover 3016 on the first seat 300 can also well isolate noise generated by the driving piece 356, so as to further reduce impact of the driving piece 356 on the passenger taking the first seat 300. Because the leaning area 3019 has sufficient mounting space, a size and a shape of the driving piece 356 are less limited, to facilitate mounting of the driving piece 356.

In a vehicle-mounted environment, to adapt to the human eyes, the optical display 303 disposed on the back of the first seat 300 needs to be adjusted in a small pitch angle range, and a rotation speed required by the vehicle-mounted optical display is very low. In this implementation, a center of gravity of the display body 32 is located on the first rotation axis, to improve balance stability of the display body 32 obtained when the display body 32 rotates around the first rotation axis. It may be understood that a position of the center of gravity may alternatively be disposed at an interval from the first rotation axis. Because the worm gear and the worm may decelerate, a load requirement on the driving piece 356 is not high. The driving piece 356 may use a stepper motor, and the stepper motor may slowly drive the worm. In addition, initial vibration and noise of the stepper motor can be controlled to a small value, and lives of the stepper motor and a transmission system is longer.

In another implementation of this application, the driving piece 356 may also be a motor of another type, for example, a direct current deceleration motor, an alternating current motor, or a servo motor, and a deceleration box, an anti-blocking apparatus, an angle detection sensor, an encoder, or the like may be added to the driving piece 356 based on a function requirement.

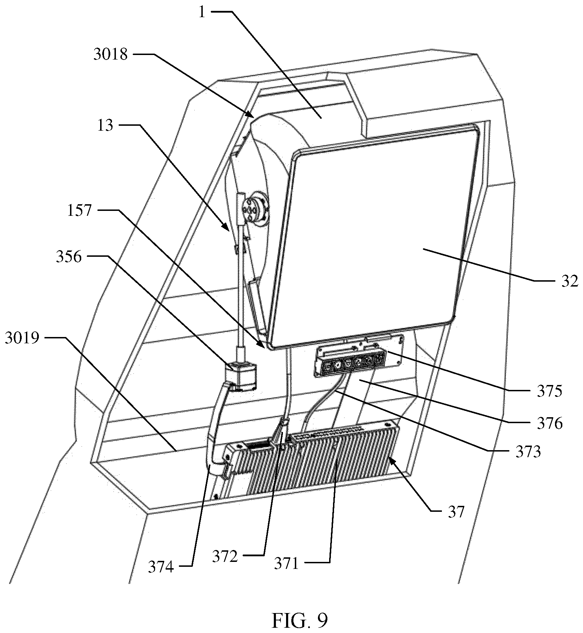

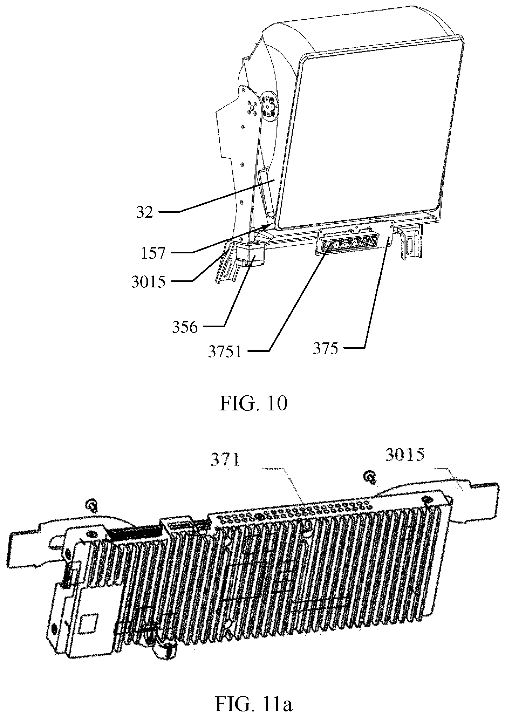

Refer to FIG. 9 and FIG. 10. The electrical component 37 includes a main controller 371, a first cable 372, a second cable 373, a third cable 374, a control panel 375, and a fourth cable 376.

The main controller 371 is fastened to the framework 3015 (as shown in FIG. 11a), is located in the leaning area 3019, and is configured to control the light source unit 3 and the driving piece 356. Because the main controller 371 is located in the leaning area 3019 and does not occupy space of the head pillow area 3018, mounting flexibility of the optical display 303 and space utilization of the accommodating cavity 3017 are improved.

The first cable 372 is electrically connected between the light source unit 3 and the main controller 371. The first cable 372 is configured to transmit, to the light source unit 3, an image signal (for example, a video signal) output by the main controller 371. The second cable 373 is electrically connected between the light source unit 3 and the main controller 371. The second cable 373 is configured to supply power to the light source unit 3, to ensure stable output of the light source unit 3. The first cable 372 and the second cable 373 may be combined into one cable.

The third cable 374 is electrically connected between the main controller 371 and the driving piece 356, and is configured to transmit, to the driving piece 356, a driving signal output by the main controller 371, so that the main controller 371 controls the driving piece 356.

The control panel 375 is fastened to the framework 3015 (as shown in FIG. 10) and is located on a side on which the fourth side part 157 of the display body 32 is located. The control panel 375 is disposed in the leaning area 3019, so as not to occupy the space of the head pillow area 3018. The fourth cable 376 is electrically connected between the control panel 375 and the main controller 371, so that the user controls the display body 32 through the control panel 375. A button 3751 may be disposed on the control panel 375. The button 3751 includes a physical button, a touch button, a touchscreen, and the like.

When the driving piece 356 drives the display body 32 to rotate, a position of the display body 32 relative to each component of the electrical component 37 needs to be continuously changed to adapt to the viewer, that is, the display body 32 and the electrical component 37 move relative to each other, and cables between the display body 32 and the electrical component 37 need to be redundant to reduce cable movement as much as possible. Because the driving piece 356, the control panel 375, and the main controller 371 are all fastened to the framework 3015, when the display body 32 rotates, the light source unit 3 rotates with the display body 32, and the driving piece 356, the control panel 375, and the main controller 371 are static relative to each other. Therefore, the first cable 372 and the second cable 373 between the light source unit 3 and the main controller 371 need a large redundancy, while a redundancy of the third cable 374 between the main controller 371 and the driving piece 356 may be reduced, and a redundancy of the fourth cable 376 between the control panel 375 and the main controller 371 may be reduced.

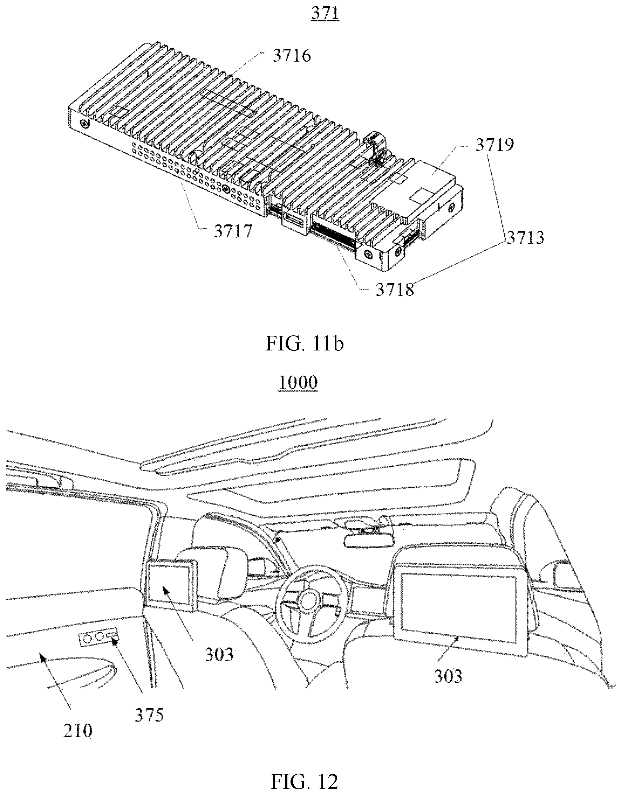

In some implementations of this application, as shown in FIG. 11a, the main controller 371 may be fastened to the framework 3015 through a fastener (for example, a screw). Refer to FIG. 11b. The main controller 371 includes a main control chip (not shown in the figure) and a protective housing 3713, and the protective housing 3713 is fixedly sleeved outside the main control chip. A heat dissipation structure is disposed on the protective housing 3713, and is configured to dissipate heat generated by the main control chip. The heat dissipation structure includes heat sink fins 3716 and heat sink through holes 3717 that are disposed on the protective housing 3713, to improve heat dissipation efficiency of the main controller 371. The protective housing 3713 may include an upper housing 3718 and a lower housing 3719 that cover each other. For example, the upper housing 3718 and the lower housing 3719 may be made by using different processes or a same process. For example, the upper housing 3718 may be a die casting housing, and the lower housing may be a sheet metal housing. It may be understood that a structure and a manufacturing process of the protective housing 3713 are not limited in this application.

A disposition position of the main controller 371 is not limited in this application. In another implementation of this application, the main controller 371 may be further disposed at another position. For example, if space of the head pillow area 3018 of the first seat 300 is sufficient, the main controller 371 may be disposed on the back part 13 of the housing 1. The main controller 371 may be communicatively connected to the light source unit 3 of the display body 32 in a wired manner or in a wireless manner.

In another implementation of this application, the fourth cable 376 may be omitted, and the control panel 375 may be communicatively connected to the main controller 371 in a wireless manner, that is, the control panel 375 may be a remote control. The control panel 375 may be disposed around the display body 32, or may be disposed at a handrail of the second seat 500. In some implementations of this application, the outside of the control panel 375 is shielded by a cover to protect the control panel 375. The control panel 375 may be alternatively directly connected to the housing 1.

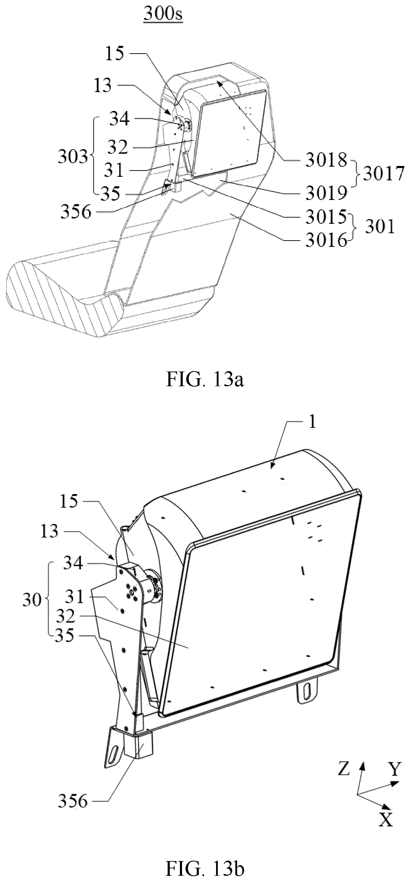

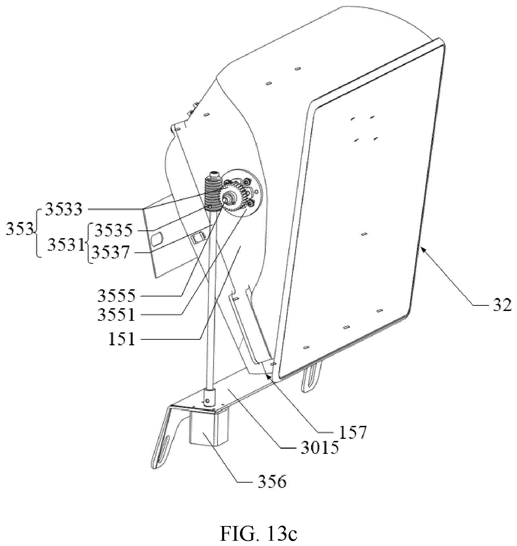

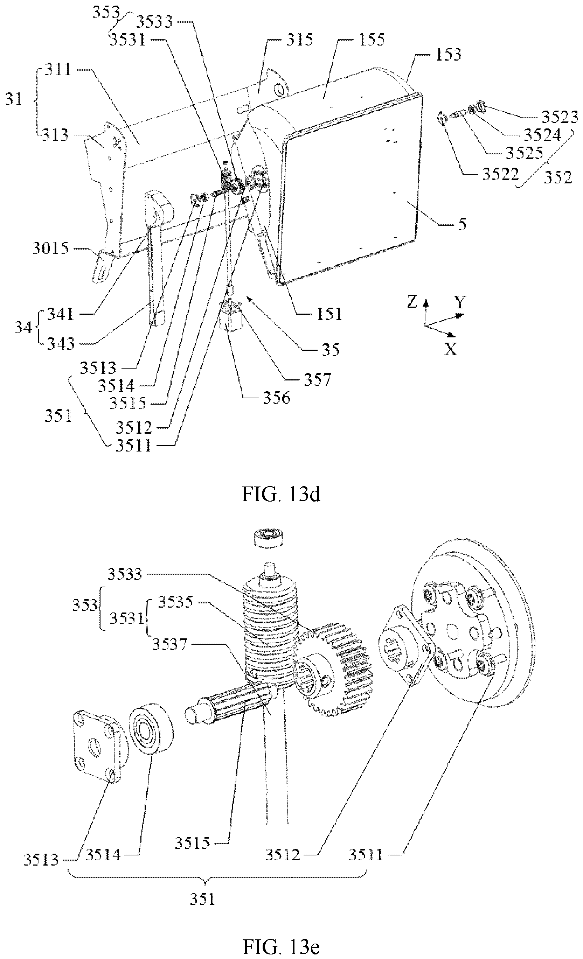

Refer to FIG. 13a, FIG. 13b, FIG. 13c, and FIG. 13d. A structure of a first seat 300s provided in a second implementation of this application is approximately the same as the structure of the first seat provided in the first implementation, and a difference lies in a structure of the pitch mechanism 35.

The package housing 34 includes the first packaging part 341 and the second packaging part 343 that are disposed in a connected manner, and the pitch mechanism 35 further includes a first connection assembly 351, a vibration isolating piece 357, and a second connection assembly 352. The first connection assembly 351 is at least partially accommodated in the first packaging part 341. The first connection assembly 351 is connected between the first support arm 313 and the first side part 151, and the second connection assembly 352 is connected between the second support arm 315 and the second side part 153, so that the support 31 is rotatively connected to the display body 32. The transmission assembly 353 is drive-connected to the first connection assembly 351, and the driving piece 356 is drive-connected to the transmission assembly 353. The transmission assembly 353 is configured to transfer, to the first connection assembly 351, power output by the driving piece 356, so that the display body 32 rotates relative to the support 31. The vibration isolating piece 357 is located between the driving piece 356 and the framework 3015, and is configured to block vibration of the driving piece 356 from being conducted to a passenger on the first seat 300s through the framework 3015 and being perceived by the passenger, so that mute adjustment can be implemented, and an immersive viewing effect of the viewer on the optical display 303 can be ensured.

Refer to FIG. 13d and FIG. 13e. The first connection assembly 351 includes a boss 3511, a flange 3512, a flange bearing sleeve 3513, a bearing 3514, and the rotating shaft 3515. The boss 3511 is fastened to the first side part 151, and the flange 3512 is fastened to the boss 3511. The flange bearing sleeve 3513 is fastened to an inner side surface that is of the first support arm 313 and that faces the first side part 151. The bearing 3514 is fixedly accommodated in the flange bearing sleeve 3513. The rotating shaft 3515 is rotatively connected to the bearing 3514. The rotating shaft 3515 penetrates the worm gear 3533 and the flange 3512. The rotating shaft 3515 is connected to the worm gear 3533 in a manner of stopping rotating, and the rotating shaft 3515 is connected to the flange 3512 in a manner of stopping rotating, so that the rotating shaft 3515 is connected to the first side part 151 in a manner of stopping rotating.

In this implementation, the flange 3512 is a spline flange, the rotating shaft 3515 is a spline shaft, the worm gear 3533 is provided with a spline hole, the flange 3512 is splined with the rotating shaft 3515, and the worm gear 3533 is splined with the rotating shaft 3515. By splining, rotation of the rotating shaft 3515 relative to the display body 32 can be limited, to improve stability of the display body 32 when moving around the first rotation axis. In another implementation of this application, the rotating shaft 3515 may not be a spline shaft, and the flange 3512 may not be a spline flange.

Refer to FIG. 13d again. A structure of the second connection assembly 352 is similar to that of the first connection assembly 351, and the second connection assembly 352 includes a flange 3522, a flange bearing sleeve 3523, a bearing 3524, and a rotating shaft 3525. The flange 3522 is fastened to the second side part 153. The flange bearing sleeve 3523 is fastened to the second support arm 315. The bearing 3524 is fixedly accommodated in the flange bearing sleeve 3523. The rotating shaft 3525 is rotatively connected to the bearing 3524, so that the second side part 153 is rotatively connected to the second support arm 315. Because both the first side part 151 and the second side part 153 are rotatively connected to the support 31, rotation stability of the display body 32 is improved.

Structures of the first connection assembly 351 and the second connection assembly 352 are not limited in this application. For example, the second connection assembly 352 may be omitted, and the first connection assembly 351 may implement a rotating connection between the support 31 and the display body 32.

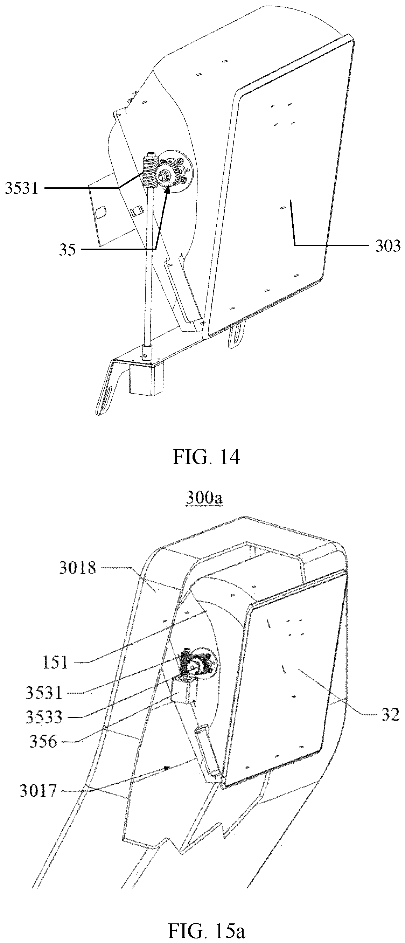

It may be understood that, in another implementation of this application, as shown in FIG. 14, the worm 3531 may alternatively be a multi-head worm to implement semi-self-locking. An external force exceeding a specific size may drive the display body 32 to rotate, so as to prevent the pitch mechanism 35 of the optical display 303 from being damaged by the external force, and ensure that an angle of the optical display 303 remains stable. The pitch mechanism 35 may further include an anti-blocking apparatus, to prevent damage to the driving piece 356 caused by reverse driving.

The driving piece 356 may be flexibly placed based on internal space of the accommodating cavity 3017 and by setting different lengths and pitch angles of the rod body 3537. For example, the driving piece 356 may be located on a side on which the first side part 151 of the display body 32 is located, on a side on which the second side part 153 is located, on a side on which the third side part 155 is located, on a side on which the fourth side part 157 is located, or on a side on which the back part 13 is located. In other words, the driving piece 356 may be disposed on a side part, the top, and the bottom of the display body 32.

In a possible implementation, as shown in FIG. 15a, in a first seat 300a, the worm gear 3533 is connected to the first side part 151, a rod body may be omitted in the worm 3531, the driving piece 356 is located on the side on which the first side part 151 of the display body 32 is located, the driving piece 356 is disposed adjacent to the worm gear 3533, and the driving piece 356 is located at or disposed close to the head pillow area 3018. In this way, a structure of the transmission assembly is simplified, and space of the accommodating cavity 3017 on the side on which the first side part 151 of the display body 32 is located is fully utilized.

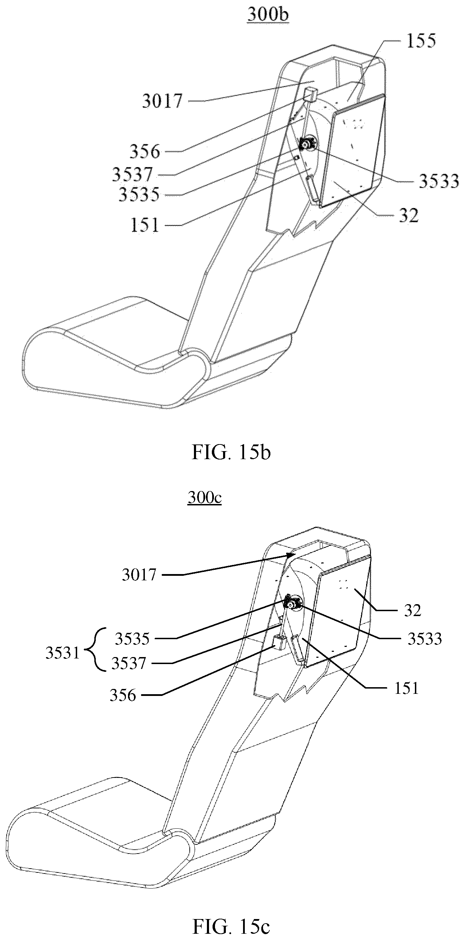

In a possible implementation, as shown in FIG. 15b, in a first seat 300b, the worm gear 3533 is connected to the first side part 151, the rod body 3537 of the worm 3531 extends toward the top of the first seat 300b, the driving piece 356 extends out of the side on which the third side part 155 of the display body 32 is located, and there is a specific distance between the driving piece 356 and the worm head 3535 in an axial direction of the worm head 3535. In this way, space of the accommodating cavity 3017 on the side on which the third side part 155 of the display body 32 is located is used, and impact of noise or vibration generated by the driving piece 356 on a human ear of a passenger on the first seat 300b is reduced.

In a possible implementation, as shown in FIG. 15c, in a first seat 300c, the worm gear 3533 is connected to the first side part 151, the rod body 3537 of the worm 3531 extends toward the bottom of the first seat 300c, the driving piece 356 is located on the side on which the first side part 151 of the display body 32 is located, and there is a specific distance between the driving piece 356 and the worm head 3535 in the axial direction of the worm head 3535. In this way, space of the accommodating cavity 3017 on the side on which the first side part 151 of the display body 32 is located is used, and impact of noise or vibration generated by the driving piece 356 on a human ear of a passenger on the first seat 300c is reduced.

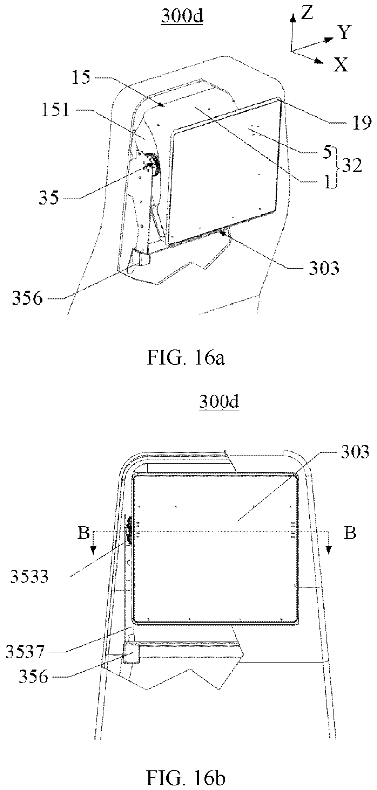

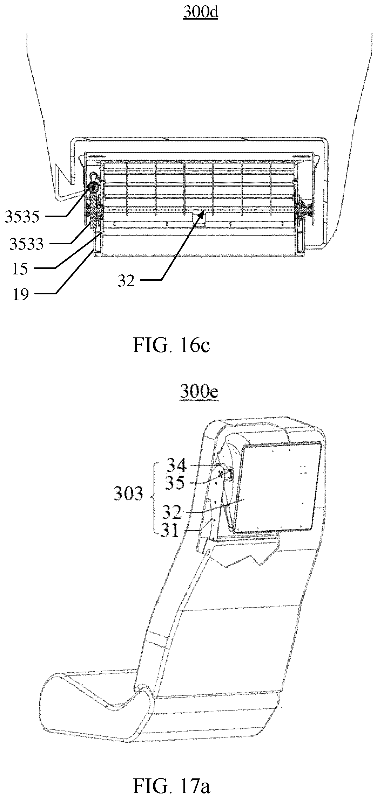

In a possible implementation, as shown in FIG. 16a, FIG. 16b, and FIG. 16c, in a first seat 300d, the display body 32 further has a mounting part 19 configured to fasten the transflective optical element 5, and the mounting part 19 is protrudingly disposed on the connecting side part 15. The mounting part 19 and the connecting side part 15 form accommodating space, and the pitch mechanism 35 is accommodated in the accommodating space. In the first direction of the display body 32, the transflective optical element 5 faces the back part of the housing 1, and the pitch mechanism 35 is hidden behind the mounting part 19 and cannot be seen by a viewer. The pitch mechanism 35 reuses space of the display body 32 in the second direction, to compress a width of a non-display functional component of the optical display 303. In addition, the first connection assembly may be omitted, the worm gear 3533 may be directly fastened to the first side part 151, the rod body 3537 of the worm 3531 extends toward the bottom of the first seat 300d, and the driving piece 356 is located outside a light outlet area of the display body 32 to improve a screen-to-body ratio of the display body 32. In the axial direction of the worm head 3535, there is a specific distance between the driving piece 356 and the worm head 3535, so as to use space of the accommodating cavity 3017 below the display body 32, and reduce impact of noise or vibration generated by the driving piece 356 on a human ear of a passenger on the first seat 300d.

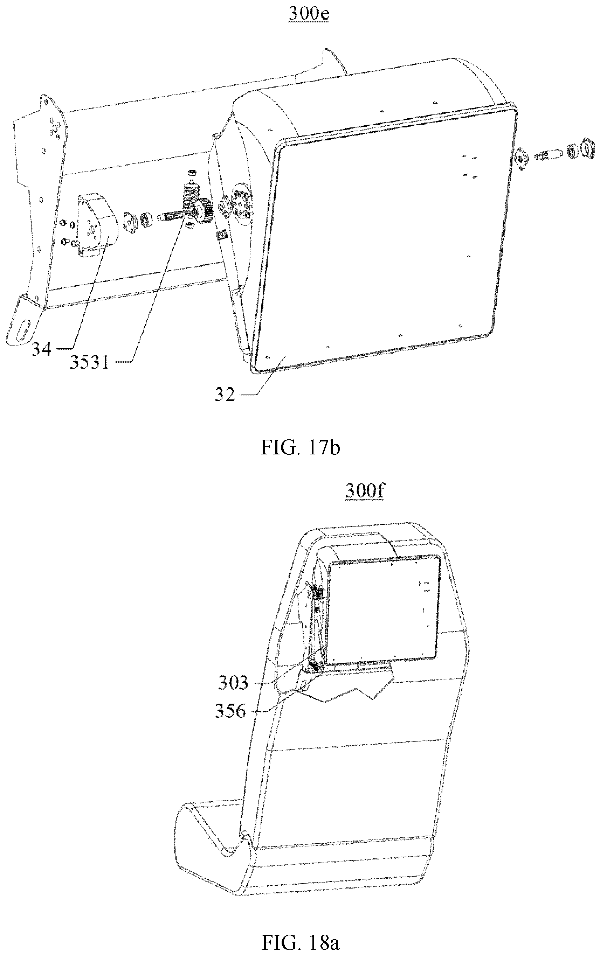

As shown in FIG. 17a and FIG. 17b, a structure of a first seat 300e provided in a third implementation of this application is approximately the same as the structure of the first seat provided in the first implementation. In the first seat 300e, the optical display 303 includes the support 31, the display body 32, the package housing 34, and the pitch mechanism 35. A difference lies in that the driving piece in the pitch mechanism 35 may be omitted, and the worm 3531 may be a multi-head worm, two ends of the worm 3531 are directly mounted into the package housing 34 through a bearing, and the display body 32 may be rotated by pushing the display body 32 by hand. Because the driving piece is omitted, a structure and assembly of the optical display 303 are simplified, and manufacturing costs of the optical display 303 are reduced.

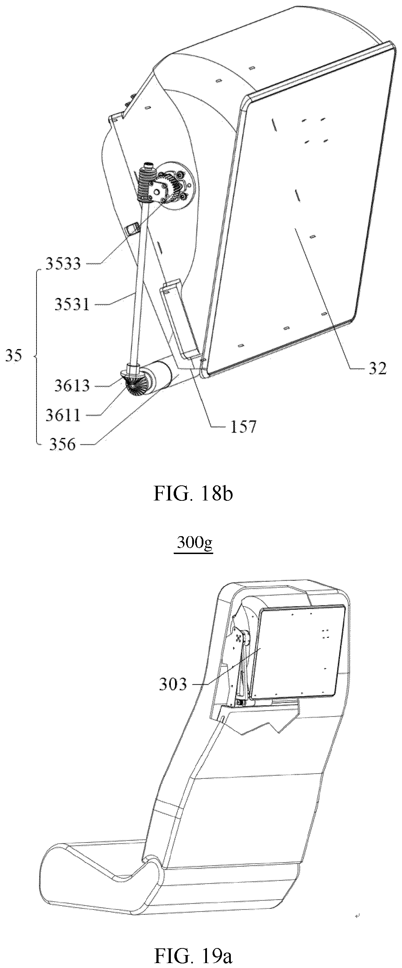

As shown in FIG. 18a and FIG. 18b, a structure of a first seat 300f provided in a fourth implementation of this application is approximately the same as the structure of the first seat provided in the first implementation. A difference lies in that in the first seat 300f, the driving piece 356 is located on the side on which the fourth side part 157 of the display body 32 is located, and the pitch mechanism 35 further includes a first tapered steering gear 3611 and a second tapered steering gear 3613 that are engaged with each other, where the first tapered steering gear 3611 is connected to the driving piece 356, the second tapered steering gear 3613 is fixedly connected to a first transmission structure 3531, the driving piece 356 is configured to drive the first tapered steering gear 3611 to rotate, the rotation of the first tapered steering gear 3611 drives the second tapered steering gear 3613 to rotate, and the first transmission structure 3531 is driven by the rotation of the second tapered steering gear 3613, so as to drive a second transmission structure 3533 to rotate. The first transmission structure 3531 may be but is not limited to a worm, and the second transmission structure 3533 may be but is not limited to a worm gear. The tapered steering gear is added to the first transmission structure 3531, so that the driving piece 356 may be placed horizontally instead of vertically, and is placed right below the optical display 303. In this way, a length of the driving piece 356 of the optical display 303 is not limited. The driving piece 356 may be a deceleration motor, and a pitch adjustment torque requirement of the vehicle-mounted optical display is met by decelerating and increasing a torque. This helps reduce costs of the driving piece 356. Alternatively, based on a requirement, functional components such as anti-blocking, an angle sensor, and an encoder may be added to the pitch mechanism 35 in a length direction of the driving piece 356.

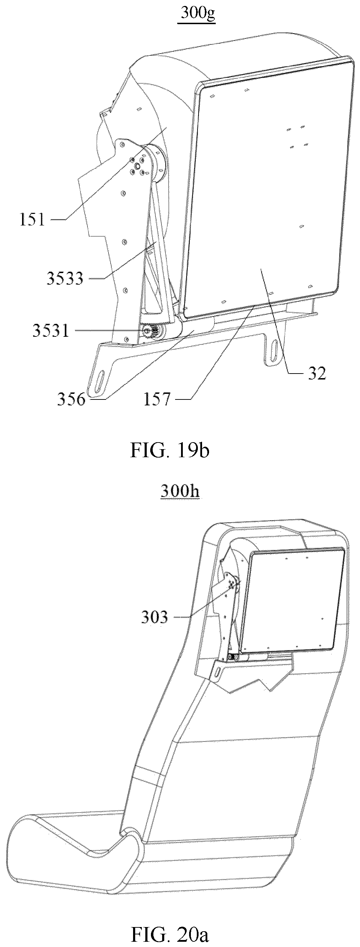

Refer to FIG. 19a and FIG. 19b. A structure of a first seat 300g provided in a fifth implementation of this application is approximately the same as the structure of the first seat provided in the first implementation. A difference lies in that in the first seat 300g, the first transmission structure includes a first gear 3531, the first gear 3531 is connected to the driving piece 356, the second transmission structure includes a sector gear 3533 fixedly connected to the first side part 151 of the connecting side part, the sector gear 3533 is engaged with the gear 3531, and the driving piece 356 is configured to drive the gear 3531 to rotate, so as to drive the sector gear 3533 to rotate, and further drive the display body 32 to rotate. The driving piece 356 may be located below the fourth side part 157 of the connecting side part. A transmission structure obtained when the sector gear is used for transmission is more compact than that obtained when the worm gear and the worm are used for transmission. It may be understood that the second transmission structure may alternatively be connected to another position of the connecting side part, for example, the second side part, the third side part, or the fourth side part. The driving piece 356 may be located in another position of the first seat 300.

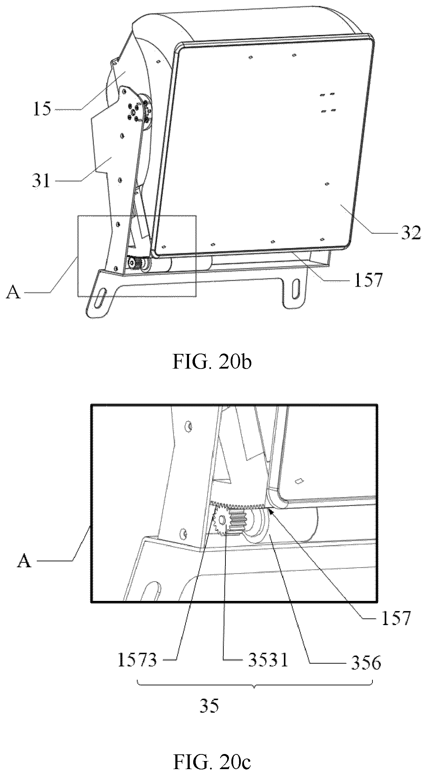

Refer to FIG. 20a, FIG. 20b, and FIG. 20c. A structure of a first seat 300h provided in a sixth implementation of this application is approximately the same as the structure of the first seat provided in the first implementation. In the first seat 300h, the support 31 is rotatively connected to the connecting side part 15. A difference lies in that the driving piece 356 may be located below the fourth side part 157 of the connecting side part 15, the first transmission structure includes the first gear 3531 fixedly connected to the driving piece 356, the second transmission structure includes an arc tooth part 1573 disposed on the fourth side part 157 of the connecting side part, the arc tooth part 1573 is engaged with the first gear 3531, and the driving piece 356 is configured to drive the first gear 3531 to rotate, so as to drive the display body 32 to rotate. In this implementation, the arc tooth part 1573 is an arc-shaped rack structure disposed on the fourth side part 157. The arc tooth part 1573 is directly integrated with the housing 1, and the transmission structure does not additionally occupy a width space of the optical display 303. The arc tooth part 1573 may alternatively be disposed at another position of the connecting side part, for example, the first side part, the second side part, and the third side part. The driving piece 356 may be disposed at another position of the first seat 300h.

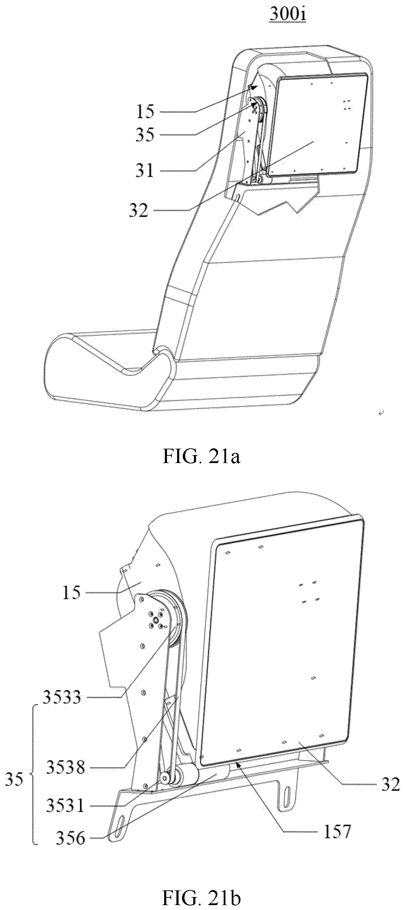

Refer to FIG. 21a and FIG. 21b. A structure of a first seat 300i provided in a seventh implementation of this application is approximately the same as the structure of the first seat provided in the first implementation. In the first seat 300i, the support 31 is rotatively connected to the connecting side part 15. A difference lies in that the driving piece 356 may be located below the fourth side part 157 of the connecting side part 15, the first transmission structure includes a first belt wheel 3531, the first belt wheel 3531 is connected to the driving piece 356, the second transmission structure includes a second belt wheel 3533, the second belt wheel 3533 is fixedly connected to the connecting side part 15, the pitch mechanism 35 further includes a transmission belt 3538, the transmission belt 3538 is sleeved on the first belt wheel 3531 and the second belt wheel 3533, the driving piece 356 is configured to drive the first belt wheel 3531 to rotate, and the transmission belt 3538 drives the second belt wheel 3533 to rotate, so as to implement rotation of the display body 32. The belt wheel and the transmission belt are used for transmission, to facilitate mounting of the pitch mechanism and the display body 32, and improve assembly efficiency of the optical display 303.

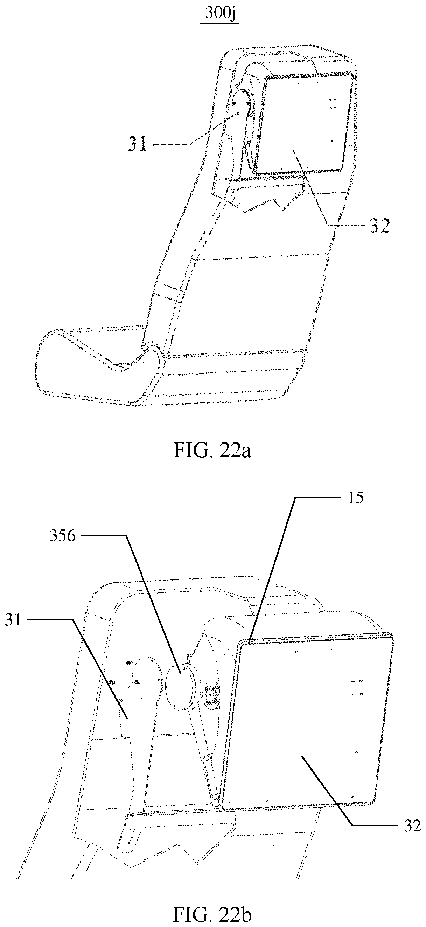

Refer to FIG. 22a and FIG. 22b. A structure of a first seat 300j provided in an eighth implementation of this application is approximately the same as the structure of the first seat provided in the first implementation. A difference lies in that in the first seat 300j, a transmission assembly is omitted in the pitch mechanism, and the driving piece 356 may be directly fastened to the support 31, and the driving piece 356 is connected to the connecting side part 15. In other words, the driving piece 356 is located between the support 31 and the display body 32. The driving piece 356 may be integrated with the display body 32. This simplifies the structure of the optical display. The driving piece 356 may be a thin deceleration direct drive motor.

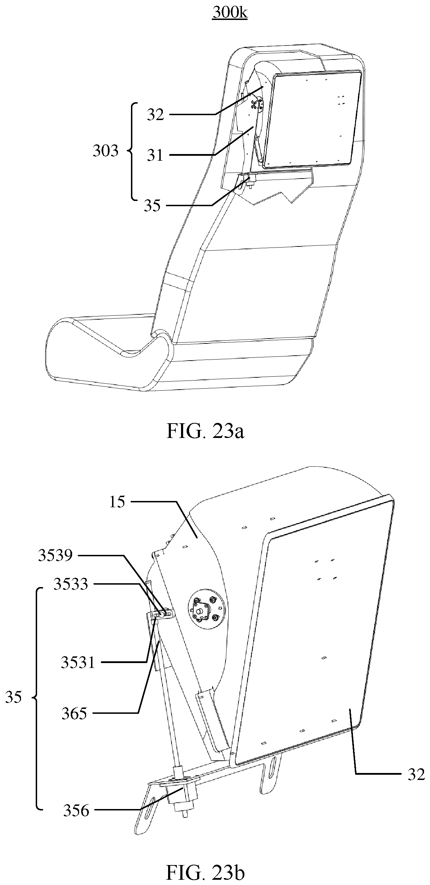

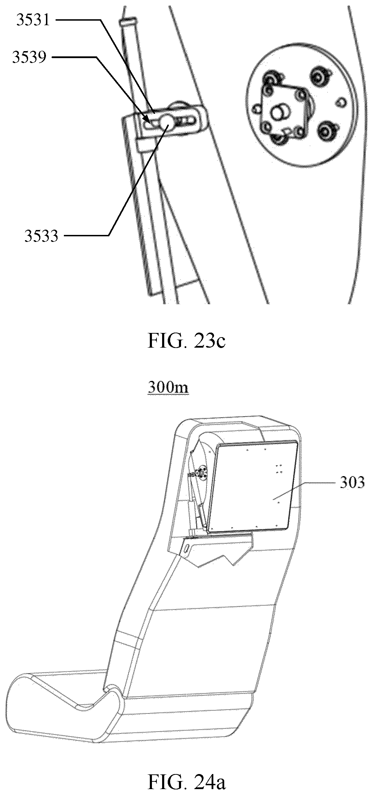

Refer to FIG. 23a, FIG. 23b, and FIG. 23c. A structure of a first seat 300k provided in a ninth implementation of this application is approximately the same as the structure of the first seat provided in the first implementation. In the first seat 300k, the second transmission structure is connected to the connecting side part 15, and the second transmission structure is rotatively connected to the support 31. A difference lies in that the first transmission structure includes a moving piece 3531, the second transmission structure includes a coupling shaft 3533, the coupling shaft 3533 is slidingly connected to the moving piece 3531, and the coupling shaft 3533 is rotatively connected to the support 31. The moving piece 3531 may be a hinge. The driving piece 356 is configured to drive the moving piece 3531 to perform a linear movement, so that the coupling shaft 3533 drives the display body 32 to perform a rotational movement. The moving piece 3531 is provided with a sliding slot 3539, and the coupling shaft 3533 penetrates the sliding slot 3539 and is slidingly connected to the sliding slot 3539. The pitch mechanism 35 further includes a lead screw 365, and the moving piece 3531 is screw-connected to the lead screw 365. The driving piece 356 is configured to drive the lead screw 365 to rotate. The driving piece 356 may be a lead screw motor. The driving piece 356 drives the lead screw 365 to rotate, and the lead screw 365 drives the moving piece 3531 to perform a linear movement in an axial direction (a fourth direction) of the lead screw 365. Because the coupling shaft 3533 is slidingly connected to the moving piece 3531, and the coupling shaft 3533 is rotatively connected to the support 31, the linear movement of the moving piece 3531 drives the display body 32 to rotate relative to the support 31.

The lead screw is used for transmission, so that space occupied by the pitch mechanism 35 can be reduced, and angle control precision of the optical display 303 can be improved. In addition, the sliding slot 3539 guides sliding of the second transmission structure relative to the first transmission structure, to improve rotation smoothness of the display body 32.

In another implementation of this application, a structure of the moving piece 3531 is not limited, and a manner of connecting the moving piece 3531 to the coupling shaft 3533 is not limited.

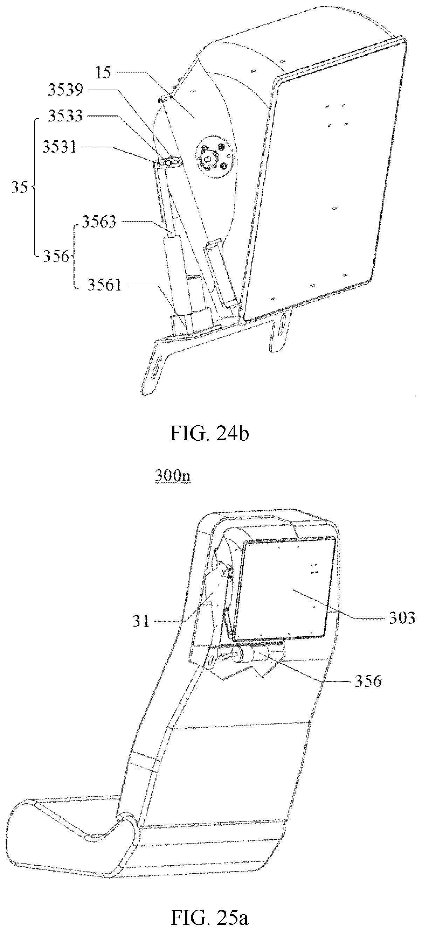

Refer to FIG. 24a and FIG. 24b. A structure of a first seat 300m provided in a tenth implementation of this application is approximately the same as the structure of the first seat provided in the ninth implementation. In the first seat 300m, the second transmission structure is connected to the connecting side part 15, and the second transmission structure is rotatively connected to the support. The first transmission structure includes the moving piece 3531, the second transmission structure includes a coupling shaft 3533, the coupling shaft 3533 is slidingly connected to the moving piece 3531, and the coupling shaft 3533 is rotatively connected to the support 31. The moving piece 3531 may be a hinge. The moving piece 3531 is provided with the sliding slot 3539, and the coupling shaft 3533 penetrates the sliding slot 3539 and is slidingly connected to the sliding slot 3539. A difference lies in that the driving piece 356 is a push rod motor. The driving piece 356 includes a driving body 3561 and an output shaft 3563. The driving body 3561 drives the output shaft 3563 to perform a linear movement. The moving piece 3531 is disposed on the output shaft 3563. The driving body 3561 drives the output shaft 3563 to perform a linear movement in an axial direction of the output shaft 3563, to drive the moving piece 3531 to perform a linear movement. Because the coupling shaft 3533 is slidingly connected to the moving piece 3531, and the coupling shaft 3533 is rotatively connected to the support 31, the linear movement of the moving piece 3531 drives the display body 32 to rotate relative to the support 31.

The push rod motor is used for transmission, so that the space occupied by the pitch mechanism 35 can be reduced, and angle control precision of the optical display 303 can be improved.

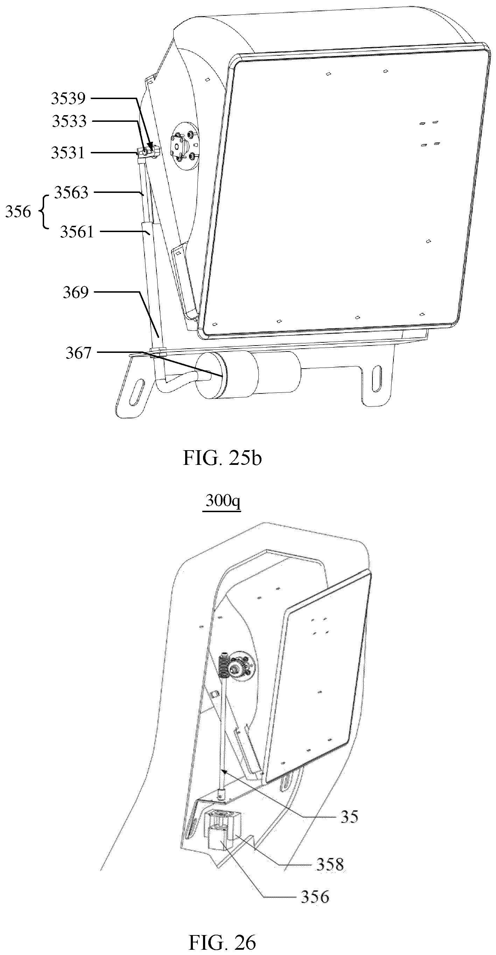

In a possible implementation, refer to FIG. 25a and FIG. 25b. A structure of a first seat 300n provided in an eleventh implementation of this application is approximately the same as the structure of the first seat provided in the ninth implementation. In the first seat 300n, the second transmission structure is connected to the connecting side part 15, and the second transmission structure is rotatively connected to the support. The first transmission structure includes the moving piece 3531, the second transmission structure includes the coupling shaft 3533, the coupling shaft 3533 is slidingly connected to the moving piece 3531, and the coupling shaft 3533 is rotatively connected to the support 31. The moving piece 3531 may be a hinge. The moving piece 3531 is provided with the sliding slot 3539, and the coupling shaft 3533 penetrates the sliding slot 3539 and is slidingly connected to the sliding slot 3539. A difference lies in that the driving piece 356 is a cylinder. The driving piece 356 includes the driving body 3561 and the output shaft 3563. The driving body 3561 drives the output shaft 3563 to perform a linear movement. The moving piece 3531 is disposed on the output shaft 3563. The driving body 3561 drives the output shaft 3563 to perform a linear movement in the axial direction of the output shaft 3563, to drive the moving piece 3531 to perform a linear movement. Because the coupling shaft 3533 is slidingly connected to the moving piece 3531, and the coupling shaft 3533 is rotatively connected to the support 31, the linear movement of the moving piece 3531 drives the display body 32 to rotate relative to the support 31.

The pitch mechanism further includes an air pump 367 and a gas supply pipe 369, where the gas supply pipe 369 is connected between the driving body 3561 and the air pump 367. The air pump is used for transmission, so that space occupied by the pitch mechanism can be reduced, and mounting flexibility of the optical display 303 can be improved.

Refer to FIG. 26. A structure of a first seat 300q provided in a twelfth implementation of this application is approximately the same as the structure of the first seat provided in the first implementation. A difference lies in that the pitch mechanism 35 further includes a noise reduction piece 358, and the noise reduction piece 358 wraps an outer surface of the driving piece 356, to help reduce vibration and noise generated by the driving piece 356. The noise reduction piece 358 may be made of a material with a strong noise reduction and sound absorption capability, for example, sound absorption cotton.

The first implementations to the twelfth implementation may be combined with each other.

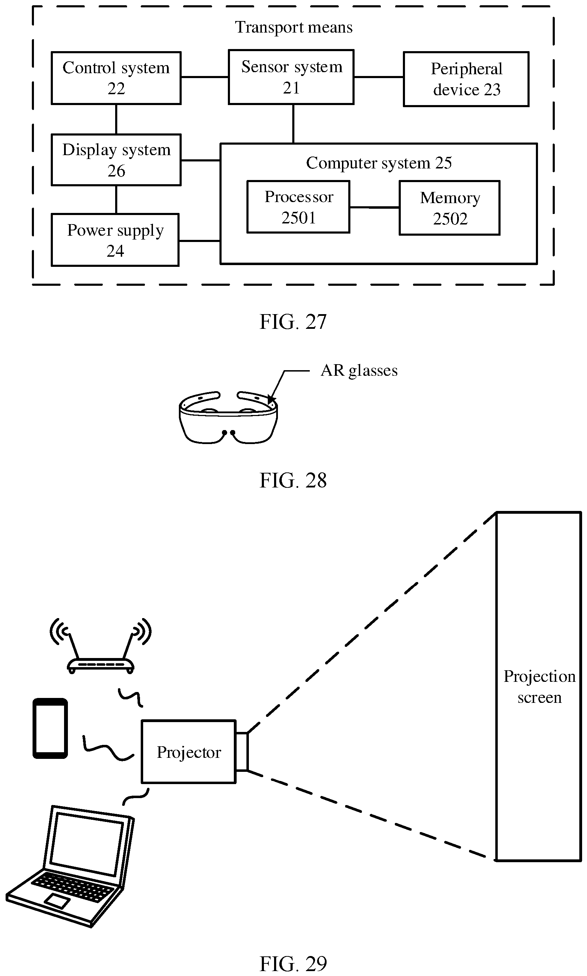

Refer to FIG. 27. FIG. 27 is a functional diagram of a transport means 1000 according to an implementation of this application.

The transport means may include various subsystems, for example, a sensor system 21, a control system 22, one or more peripheral devices 23 (one peripheral device is used as an example in the figure), a power supply 24, a computer system 25, and a display system 26 in the figure. The foregoing subsystems may communicate with each other. The display system 26 may include a display apparatus provided in an implementation of this application. The transport means may further include another functional system, for example, an engine system that provides power for the transport means or a cockpit. This is not limited herein in this application.

The sensor system 21 may include several detection apparatuses. The detection apparatuses can sense measured information, and convert the sensed information into an electrical signal or other information in a required form based on a specific rule for output. As shown in FIG. 27, the detection apparatuses may include a global positioning system (Global Positioning System, GPS), a vehicle speed sensor, an inertial measurement unit (Inertial Measurement Unit, IMU), a radar unit, a laser rangefinder, a camera apparatus, a wheel speed sensor, a steering sensor, a gear sensor, another element used for automatic detection, or the like. This is not limited in this application.

The control system 22 may include several elements, for example, a steering unit, a brake unit, a lighting system, an autonomous driving system, a map navigation system, a network time system, and an obstacle avoidance system shown in the figure. The control system 22 may receive information (such as a vehicle speed and a vehicle distance) sent by the sensor system 21, to implement functions such as autonomous driving and map navigation.

Optionally, the control system 22 may further include elements such as a throttle controller and an engine controller that are configured to control a driving speed of a vehicle, and the like. This is not limited in this application.

The peripheral device 23 may include several elements such as a communication system, a touchscreen, a user interface, a microphone, and a speaker. The communication system is configured to implement network communication between the transport means and another device other than the transport means. In actual application, the communication system may implement network communication between the transport means and another device by using a wireless communication technology or a wired communication technology. The wired communication technology may mean that a vehicle communicates with the another device through a network cable, an optical fiber, or the like.

The power supply 24 represents a system for providing power or energy for the vehicle, and may include but is not limited to a rechargeable lithium battery or a lead-acid battery. In actual application, one or more battery assemblies in the power supply are configured to provide electrical energy or energy for starting the vehicle. A type and a material of the power supply are not limited in this application.

Several functions of the transport means may be controlled and implemented by the computer system 25. The computer system 25 may include one or more processors 2501 (one processor is shown as an example in the figure) and a memory 2502 (which may also be referred to as a storage apparatus). In actual application, the memory 2502 is also inside the computer system 25, or may be outside the computer system 25, for example, used as a cache in the transport means. This is not limited in this application.

The processor 2501 may include one or more general-purpose processors, for example, a graphics processing unit (graphics processing unit, GPU). The processor 2501 may be configured to run a related program stored in the memory 2502 or instructions corresponding to a program, to implement a corresponding function of the vehicle.

The memory 2502 may include a volatile memory (volatile memory), for example, a RAM. The memory may alternatively include a non-volatile memory (non-volatile memory), for example, a ROM, a flash memory (flash memory), an HDD, or a solid-state drive SSD. The memory 2502 may alternatively include a combination of the foregoing types of memories. The memory 2502 may be configured to store a set of program code or instructions corresponding to program code, so that the processor 2501 invokes the program code or the instructions stored in the memory 2502 to implement a corresponding function of the vehicle. In this application, the memory 2502 may store a set of program code for controlling the vehicle. The processor 2501 may control safe driving of the vehicle by invoking the program code. A manner of implementing safe driving of the vehicle is specifically described in detail below in this application.

Optionally, in addition to storing the program code or the instructions, the memory 2502 may store information such as a road map, a driving route, and sensor data. The computer system 25 may implement a vehicle-related function in combination with other elements in the diagram of the functional framework of the vehicle, for example, a sensor and a GPS in the sensor system. For example, the computer system 25 may control a driving direction, a driving speed, or the like of the transport means based on data input of the sensor system 21. This is not limited in this application.

The display system 26 may interact with another system in the transport means. For example, the display system 26 may display navigation information sent by the control system 22, or play a video sent by the computer system 25 and the peripheral device 23. For a specific structure of the display system 26, refer to the foregoing implementations of the display apparatus. Details are not described herein again.

The four subsystems shown in this implementation, namely, the sensor system 21, the control system 22, the computer system 25, and the display system 26, are merely examples, and do not constitute a limitation. In another implementation of this application, the transport means 1000 further includes a vehicle door 210, and a control panel 375 may be disposed on the vehicle door. For ease of operation, refer to FIG. 12.

In actual application, the transport means may combine several elements in the vehicle based on different functions, to obtain subsystems with corresponding different functions. In actual application, the transport means may include more or fewer subsystems or elements. This is not limited in this application.

The optical display 303 is not limited to being used in the transport means 1000 in this application, and the optical display 303 may also be used in another device. In a possible application scenario, the optical display in this application is integrated into a near eye display (Near Eye Display, NED) device, and the NED device, for example, may be an AR device or a VR device. The AR device may include but is not limited to AR glasses or an AR helmet, and the VR device may include but is not limited to VR glasses or a VR helmet. Refer to FIG. 28. The AR glasses are used as an example. A user may wear an AR glasses device to play a game, watch a video, participate in a virtual conference, perform video shopping, or the like.

In another possible application scenario, the optical display 303 in this application is integrated into a projector. Refer to FIG. 29. The projector may project an image onto a wall or a projection screen.

The foregoing application scenario is merely an example. The optical display provided in this application may be further used in another possible scenario, for example, a medical device. This is not limited in this application.

Directional terms mentioned in this application, for example, "on", "below", "front", "back", "left", "right", "inside", "outside", and "side wall", are merely directions with reference to the accompanying drawings. Therefore, the directional terms are used to better and more clearly describe and understand this application, instead of indicating or implying that a specified apparatus or element needs to have a specific orientation or be constructed and operated in a specific orientation. Therefore, this cannot be understood as a limitation on this application.

In addition, in this specification, sequence numbers, such as "first" and "second", of components are merely intended to distinguish between the described objects, and do not have any sequential or technical meaning. "Connection" in this application includes direct connection and indirect connection unless otherwise specified.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An optical display, comprising:
a display body, comprising a housing and a light source unit, wherein the housing is provided with an inner cavity, and the light source unit is accommodated in the inner cavity; and
an electrical component, located outside the housing, wherein the electrical component is communicatively connected to the light source unit.

2. The optical display according to claim 1, wherein the electrical component comprises a main controller and a first cable, and the first cable is electrically connected between the light source unit and the main controller.

3. The optical display according to claim 2, wherein the optical display further comprises a pitch mechanism communicatively connected to the main controller, the pitch mechanism is connected to the housing and is located outside the housing, and the pitch mechanism is configured to drive the display body to rotate.

4. The optical display according to claim 3, wherein the electrical component further comprises a control panel, the control panel is communicatively connected to the pitch mechanism, and the control panel is communicatively connected to the main controller.

5. The optical display according to claim 4, wherein the pitch mechanism comprises a transmission assembly and a driving piece, the transmission assembly is connected between the housing and the driving piece, and the driving piece is communicatively connected to the control panel.

6. The optical display according to claim 5, wherein the electrical component further comprises a third cable, and the third cable is electrically connected between the main controller and the driving piece.

7. The optical display according to any one of claims 4 to 6, wherein the electrical component further comprises a fourth cable, and the fourth cable is electrically connected between the main controller and the control panel.

8. The optical display according to claim 5, wherein the transmission assembly comprises a first transmission structure and a second transmission structure that are disposed in a connected manner, the first transmission structure is connected to the driving piece, and the second transmission structure is fixedly connected to the housing.

9. The optical display according to claim 8, wherein the first transmission structure comprises a worm, the worm is fixedly connected to the driving piece, the second transmission structure comprises a worm gear, the worm gear is fastened to the housing, and the worm is engaged with the worm gear.

10. The optical display according to claim 8, wherein the worm comprises a worm head and a rod body that are fixedly connected, the worm head is engaged with the second transmission structure, and one end that is of the rod body and that is away from the worm head is connected to the driving piece.

11. The optical display according to claim 3, wherein the optical display further comprises a package housing, and the pitch mechanism is at least partially accommodated in the package housing.

12. The optical display according to claim 2, wherein the main controller comprises a main control chip and a protective housing, the main control chip is fixedly accommodated in the protective housing, and a heat dissipation structure is disposed on the protective housing.

13. The optical display according to any one of claims 1 to 12, wherein the display body further comprises a curved mirror, the curved mirror is fastened to the housing, and the curved mirror is configured to project, to the outside of the housing, imaging light that is output by the light source unit.

14. The optical display according to any one of claims 1 to 13, wherein the display body further comprises a transflective optical element, the imaging light emitted by the light source unit is incident to the transflective optical element, the transflective optical element reflects imaging light to the curved mirror, and the curved mirror transmits the imaging light to the outside of the housing through the transflective optical element.

15. A seat, comprising a seat body and the optical display according to any one of claims 1 to 14, wherein the seat body is provided with an accommodating cavity, and a display body and an electrical component are at least partially accommodated in the accommodating cavity.

16. The seat according to claim 15, wherein the seat body further comprises a head pillow area and a leaning area that are disposed in a connected manner, and the display body is located in the head pillow area.

17. The seat according to claim 16, wherein the seat body further comprises a framework accommodated in the accommodating cavity, the electrical component comprises a main controller and a first cable, the first cable is electrically connected between a light source unit and the main controller, the main controller is fastened to the framework and is accommodated in the accommodating cavity, and the main controller is located in the leaning area.

18. The seat according to claim 17, wherein
the electrical component further comprises a pitch mechanism and a control panel that are communicatively connected, the pitch mechanism is connected to a housing, the pitch mechanism is communicatively connected to the main controller, and the control panel is fastened to the framework.

19. The seat according to claim 18, wherein
the pitch mechanism has a driving piece, the electrical component further comprises a third cable and a fourth cable, the third cable is electrically connected between the main controller and the driving piece, the fourth cable is electrically connected between the control panel and the main controller, and the driving piece is fastened to the framework.

20. A transport means, comprising the optical display according to any one of claims 1 to 14, wherein a housing is mounted on the transport means.

21. The transport means according to claim 20, wherein the optical display is located at a front passenger position of the transport means.
